# EUROPEAN PATENT APPLICATION

(11) **EP 4 095 858 A1**
(43) Date of publication of application: **30.11.2022**
(21) Application number: 22172800.9
(22) Date of filing: 11.05.2022
(51) Int. Cl.: G11C 7/04, G11C 11/00, G11C 11/16, G11C 17/16, G11C 17/02, G11C 17/18, G11C 16/34, G11C 13/00, G11C 11/22

(54) **SEMICONDUCTOR DEVICE**

(30) Priority: 27.05.2021 JP 2021088976
(71) Applicant: Renesas Electronics Corporation, Tokyo 135-0061 (JP)
(72) Inventor: MATSUBARA, Ken, Tokyo, 135-0061 (JP); ITO, Takashi, Tokyo, 135-0061 (JP); KURAFUJI, Takashi, Tokyo, 135-0061 (JP); TAITO, Yasuhiko, Tokyo, 135-0061 (JP); SAITO, Tomoya, Tokyo, 135-0061 (JP); KANDA, Akihiko, Tokyo, 135-0061 (JP)
(74) Representative: Betten & Resch

(57) **Abstract**

A semiconductor device includes a logic circuit, a memory, and a storage device. The storage device has a first special information storage region into which special information is written before a solder reflow process, a second special information storage region into which special information for updating is written after the solder reflow process, and a data storage region. The first special information storage region is constituted by a memory cell having a high reflow resistance and in which data is retained even after the solder reflow process. The second special information storage region and the data storage region are constituted by memory cells having a low reflow resistance and in which data may not be retained during the solder reflow process.

## Description

### CROSS-REFERENCE TO RELATED APPLICATIONS

The disclosure of Japanese Patent Application No. 2021-088976 filed on May 27, 2021 including the specification, drawings and abstract is incorporated herein by reference in its entirety.

### BACKGROUND

The present invention relates to a semiconductor device.

A system on a chip (SoC) that contains both a non-volatile memory and a logic are built in a variety of electronic devices. For example, Patent Document 1 discloses a semiconductor device that contains both a logic and a magnetoresistive memory (MRAM) which is a non-volatile memory.

There are disclosed techniques listed below.
[Patent Document 1] Japanese Unexamined Patent Application Publication No. 2020-205329
[Patent Document 2] WO2008/010290

Patent Document 1 discloses a technique that makes it possible to sufficiently ensure both the number of times data can be rewritten and a data retention period in a case where the magnetoresistive memory is used in a semiconductor memory device. Specifically, it is disclosed that the semiconductor memory device comprises a first magnetoresistive memory and a second magnetoresistive memory. Here, a target logic unit, the first magnetoresistive memory and the second magnetoresistive memory are formed on a single semiconductor chip, and the first magnetoresistive memory has a higher coercive force than the second magnetoresistive memory.

In addition, Patent Document 2 discloses a phase-change memory element having high heat resistance and more stable data retention properties. Specifically, a composition (content) of the element that constitutes the phase-change memory element is optimized to achieve high heat resistance and stable data retention properties.

### SUMMARY

In a manufacturing process of the SoC that contains both the non-volatile memory and the logic, a solder reflow process is performed. However, during the solder reflow process, the non-volatile memory becomes extremely hot, whereby the reflow process may not allow data to be retained.

For this reason, the non-volatile memory having high retention properties, that is, high data retention properties, has been conventionally used. However, in order to achieve high retention properties, it is necessary to increase the size of a memory cell. This leads to an increase in chip area and an increase in manufacturing cost. In addition, increasing the size of the memory cell leads to an increase in a write current.

On the other hand, it is also possible to use a non-volatile memory (one-time programmable memory) in which the memory cell is constituted by a destructive one-time programmable (OTP) cell. However, the non-volatile memory that uses the OTP cell can only be written once, and thus, it would be difficult to use in a debugging stage or the like in a flexible manner. In addition, even in a case where the OTP cell is used, the size of the memory cell is large, which leads to an increase in the chip area and manufacturing cost.

The present invention has been conceived in light of the above-described problems, and one of the objects of the present invention is to provide a semiconductor device that can suppress a decrease in retention properties and be used in a flexible manner while suppressing an increase in manufacturing cost.

The following is a brief overview of a representative embodiment among the embodiments of the present invention disclosed in the present application. The representative semiconductor device comprises a logic circuit, a volatile memory, and a storage device. The storage device has a first special information storage region into which special information is written before the solder reflow process, a second special information storage region into which special information for updating is written after the solder reflow process, and a data storage region. The first special information storage region is constituted by a memory cell having a high reflow resistance and in which data is retained even after the solder reflow process. The second special information storage region and the data storage region are constituted by memory cells having a low reflow resistance and in which data may not be retained during the solder reflow process.

To briefly describe effects obtained by the representative embodiment among the embodiments of the present invention disclosed in the present application, it is possible to use the semiconductor device in a flexible manner while suppressing an increase in manufacturing cost.

### BRIEF DESCRIPTION OF THE DRAWINGS

FIG. 1 is a block diagram showing an overview of a semiconductor device according to a first embodiment of the present invention.
FIG. 2 is a drawing showing a configuration example of a storage device according to a modification example of the first embodiment of the present invention.
FIG. 3 is a block diagram showing a configuration example of a semiconductor device according to a second embodiment of the present invention.
FIG. 4 is a drawing describing a refreshing process according to the second embodiment of the present invention.
FIG. 5 is a drawing describing the refreshing process according to a third embodiment of the present invention.
FIG. 6 is a drawing showing an example of characteristics of an MRAM-OTP cell according to a fourth embodiment of the present invention.
FIG. 7 is a block diagram showing a configuration example of the semiconductor device according to a fifth embodiment of the present invention.

### DETAILED DESCRIPTION

Hereinafter, embodiments of the present invention will be described in detail with reference to the drawings. In all of the drawings used to describe the embodiments, the same portions are denoted by the same reference sign in principle, and redundant descriptions thereof are omitted as appropriate.

### (FIRST EMBODIMENT)

### <CONFIGURATION OF SEMICONDUCTOR DEVICE>

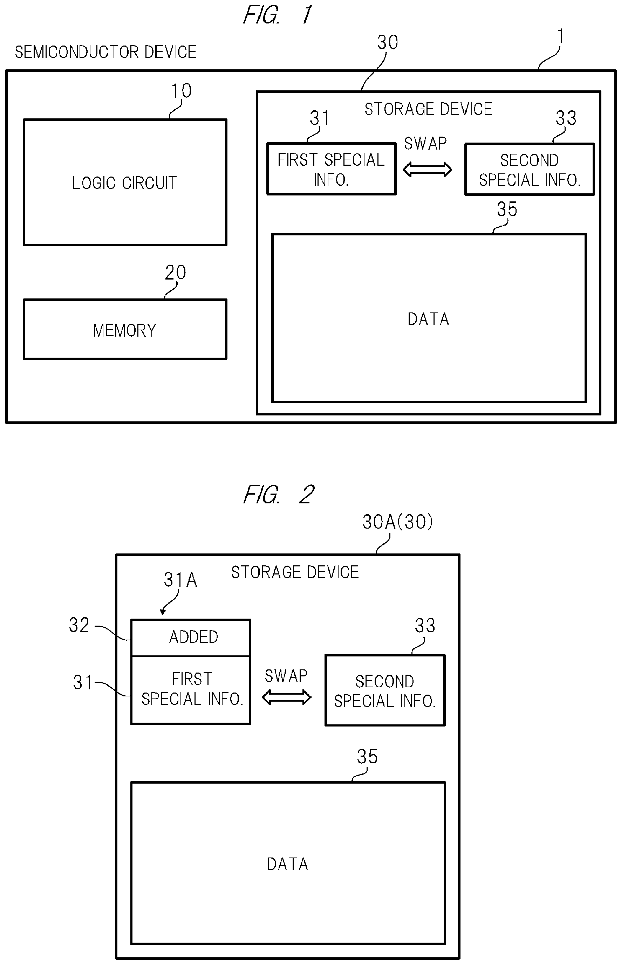

FIG. 1 is a block diagram showing a configuration example of a semiconductor device according to a first embodiment of the present invention. A semiconductor device 1 is a single-chip system LSI containing a logic circuit, an embedded non-volatile memory, and the like. As shown in FIG. 1, the semiconductor device 1 comprises a logic circuit 10, a memory 20, and a storage device 30.

The logic circuit 10 is, for example, hardware such as a memory control unit (MCU) and a central processing unit (CPU). The logic circuit 10 is configured to read out and execute various programs, parameters and the like retained in, for example, the memory 20 to achieve various functional blocks in software. In addition, the logic circuit 10 may be achieve some functions in hardware, or may achieve all functions in hardware.

The memory 20 is, for example, a volatile memory such as a static random-access memory (SRAM). The memory 20 is configured to temporarily retain, for example, various information such as a program, a parameter, and a calculation result from the logic circuit 10. Note that this information may be retained in a cache (not shown) of the logic circuit 10.

The storage device 30 is a device configured to store various information. The storage device 30 is constituted by, for example, a flash memory or a resistance-change type non-volatile memory. Examples of the resistance-change type non-volatile memory include a magnetoresistive RAM (MRAM), a phase-change RAM (PRAM), a resistive RAM (ReRAM), and the like.

In a manufacturing process of the semiconductor device 1, a solder reflow process is performed. In the solder reflow process, the semiconductor device including the storage device is in a high temperature state, whereby retention properties may decrease depending on a configuration of the memory cell. For example, increasing the size of the size of the memory cell can suppress a decrease in retention properties. However, as described above, this has a disadvantage of increasing the chip area and manufacturing cost.

Therefore, in the present embodiment, a memory cell having a high reflow resistance and a memory cell having a low reflow resistance are used separately according to the purpose of each storage region. Note that the memory cell having a high reflow resistance is a memory cell in which data is retained even after the solder reflow process, and the memory cell having a low reflow resistance is a memory cell in which data may not be retained during the solder reflow process. Using PRAM as an example, the reflow resistance varies depending on the composition (content) of an element that constitutes a memory element, as shown in Patent Document 2.

As shown in FIG. 1, the storage device 30 has a first special information storage region 31, a second special information storage region 33, and a data storage region 35.

The first special information storage region 31 is a storage region in which, for example, special information such as an initial code is stored. The special information (initial code) may include, for example, trimming information and the like. The special information is written into the storage region 31 before the solder reflow process. It is necessary for the storage region 31 to retain the special information. For this reason, the memory cell having a high reflow resistance is used for the first special information storage region 31.

On the other hand, the second special information storage region 33 is a storage region in which, for example, special information such as a code for updating code is stored. The code for updating is a code provided during an operation of the device or equipment in which the semiconductor device 1 is mounted. Namely, the code for updating is written into the storage region 33 after the solder reflow process. For this reason, the memory cell having a high reflow resistance is unnecessary for the second special information storage region 33, and the memory cell having a low reflow resistance is used for the second special information storage region 33. This makes it possible to suppress an increase in the chip area and an increase in manufacturing cost. Note that a capacity of the second special information storage region 33 may be the same as that of the first special information storage region 31.

The code to be written into the first special information storage region 31 and the second special information storage region 33 is, for example, a code for an end customer of the semiconductor device 1.

The data storage region 35 is a storage region in which various data under normal conditions are stored. The data storage region 35 is used during the operation of the device or equipment in which the semiconductor device 1 is mounted. In addition, the data storage region 35 is a storage region that is frequently rewritten. For this reason, the memory cell having a high reflow resistance is unnecessary for the data storage region 35, and the memory cell having a low reflow resistance is used for the data storage region 35. This makes it possible to suppress an increase in the chip area and an increase in manufacturing cost. This also makes it possible to reduce a write current to the data storage region 35. Note that the data storage region 35 is not limited to the non-volatile memory, and can be substituted with a volatile memory. In this case, it is sufficient to provide the data storage region 35 in the memory 20 which is the volatile memory.

### <MAIN EFFECTS OF PRESENT EMBODIMENT>

According to the present embodiment, the memory cell having a high reflow resistance is used for the first special information storage region 31 into which special information such as a predetermined initial code is written before the solder reflow process, and the memory cell having a low reflow resistance is used for the second special information storage region 33 into which the code and data for updating are written after the solder reflow process. In addition, the memory cell having a low reflow resistance is also used for the data storage region 35. According to such a configuration, it is possible to minimize the number of memory cells having a high reflow resistance and suppress an increase in manufacturing cost. In addition, it is possible to suppress a decrease in retention properties of the semiconductor device system as a whole. In addition, the memory cell that allows rewriting is used, whereby the code, data and the like can be rewritten in the debugging stage and the like, making it possible to use the semiconductor device in a flexible manner.

### ((MODIFICATION EXAMPLE))

Next, a modification example of the present embodiment will be described. FIG. 2 is a drawing showing a configuration example of the storage device according to the modification example of the first embodiment of the present invention. As shown in FIG. 2, in the present modification example, a capacity of a first special information storage region 31A is larger than that of the second special information storage region 33. Specifically, in the present modification example, the first special information storage region 31A has a configuration in which another storage region 32 is added to the first special information storage region 31 shown in FIG. 1. The memory cell having a high reflow resistance is used for the added storage region 32.

As described above, the code for, for example, the end customer of the semiconductor device 1 is written as special information into the first special information storage region 31 and the second special information storage region 33, while a code for, for example, a third party or the like is written as special information into the storage region 32. The code for a third party need not be updated. Therefore, there is no need to provide a storage region corresponding to the storage region 32 in the second special information storage region 33.

According to the present configuration, it is possible to store the special information for a third party in the storage region 32 and use the information.

### (SECOND EMBODIMENT)

Next, a second embodiment will be described. In the present embodiment, after the solder reflow process, a refreshing process is performed on the data (special information) stored in the special information storage region.

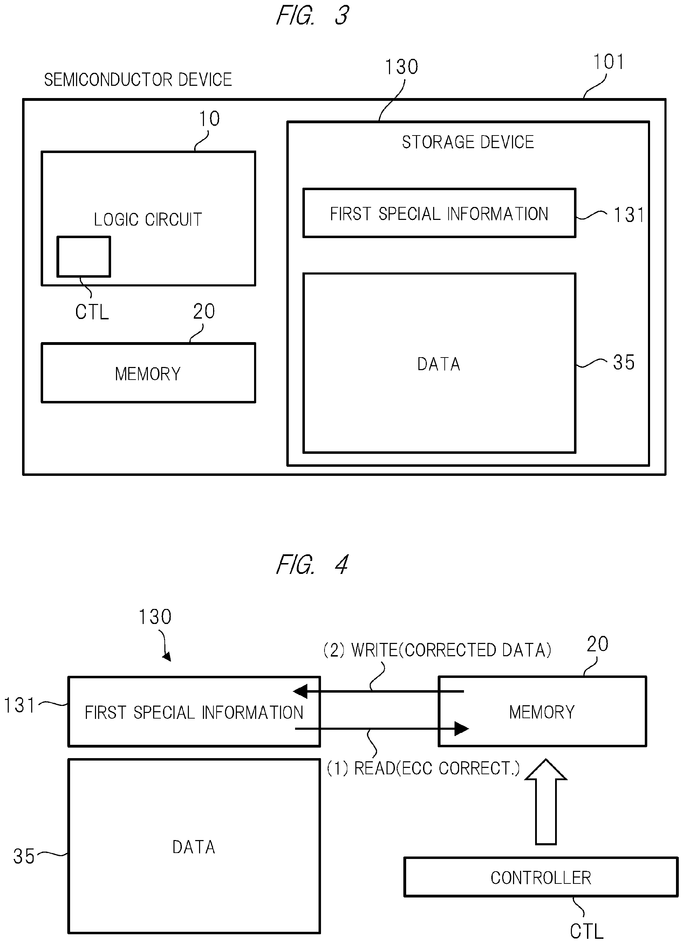

FIG. 3 is a block diagram showing a configuration example of the semiconductor device according to the second embodiment of the present invention. As shown in FIG. 3, a semiconductor device 101 of the present embodiment comprises the logic circuit 10, the memory 20, and a storage device 130.

The logic circuit 10 shown in FIG. 3 has a controller CTL configured to perform controls regarding error correction code (ECC) correction on a special information storage region 131, which will be described below. The controller CTL may be hardware or software, or may have a configuration in which hardware and software are combined.

The storage device 130 has the special information storage region 131 and the data storage region 35. The special information storage region 131 is a storage region in which, for example, special information such as the initial code is stored. Note that the memory cell having a low reflow resistance is used for the special information storage region 131. In this respect, the configuration differs from that of the first special information storage region 31 described in the first embodiment. Therefore, in the present embodiment, only the memory cell having a low reflow resistance is used for each storage region (131, 35) of the storage device 130.

However, if the solder reflow process is performed in a state where the special information is written into the special information storage region 131, the special information may not be retained in the special information storage region 131. Therefore, in the present embodiment, after the solder reflow process, the refreshing process is performed on the special information storage region 131.

### <REFRESHING>

Next, the refreshing process on the special information storage region 131 will be described. FIG. 4 is a drawing describing the refreshing process according to the second embodiment of the present invention. FIG. 4 shows the storage device 130, the memory 20, and the controller CTL.

After the solder reflow process, the controller CTL controls the memory 20 and reads out the special information from the special information storage region 131 to the memory 20. Then, the controller CTL performs ECC correction on the special information read out to the memory 20 and updates the special information retained in the memory 20 with the corrected special information. Then, the controller CTL writes the corrected special information into the special information storage region 131. In this manner, the refreshing process is performed on the special information storage region 131.

### <MAIN EFFECTS OF PRESENT EMBODIMENT>

According to the present embodiment, after the solder reflow process, the refreshing process is performed on the special information storage region 131. This makes it possible to suppress a decrease in retention properties of the semiconductor device system as a whole even if the memory cell having a low reflow resistance is used for the special information storage region 131.

In addition, it is possible to configure the storage device 130 with only the memory cell having a low reflow resistance and reduce the write current.

### (THIRD EMBODIMENT)

Next, a third embodiment will be described.

A configuration of the semiconductor device according to the present embodiment is the same as shown in FIG. 3. Note that, in the present embodiment, the refreshing process after the solder reflow process differs from that of the second embodiment.

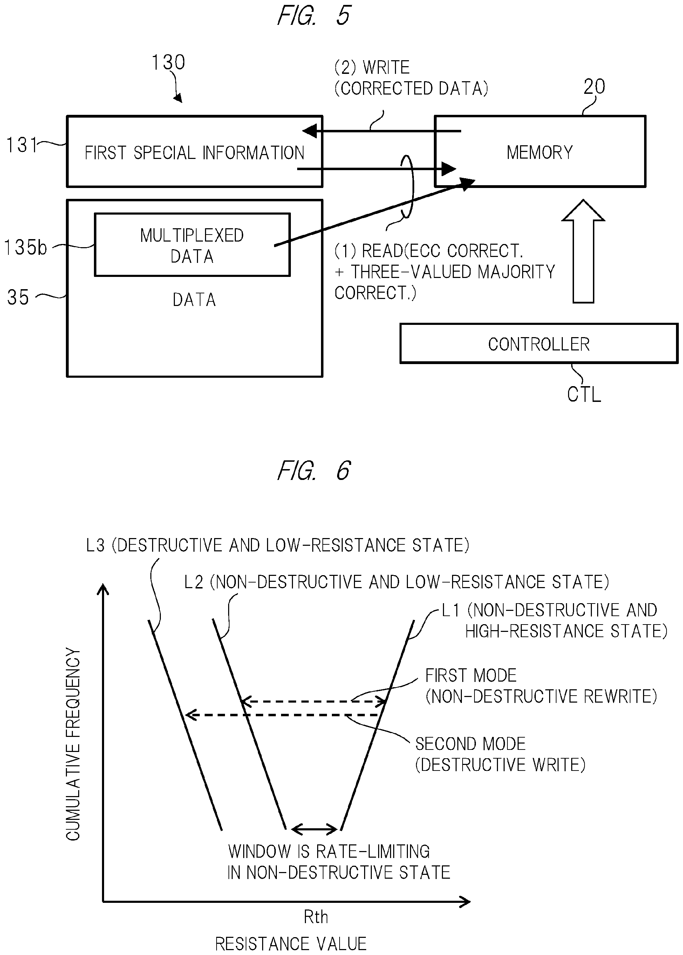

FIG. 5 is a drawing describing the refreshing process according to the third embodiment of the present invention. FIG. 5 also shows the storage device 130, the memory 20, and the controller CTL. As shown in FIG. 5, a multiplexed data storage region 135b is set in the data storage region 35. Before the solder reflow process, multiplexed special information is written into the multiplexed data storage region 135b. Examples of the multiplexed special information include information multiplexed by a three-valued majority voting and the like. Note that, although FIG. 5 shows only one multiplexed region, it may be provided in multiple locations.

After the solder reflow process, the controller CTL controls the storage device 130 (special information storage region 131 and multiplexed data storage region 135b) and the memory 20, and reads out the special information from the special information storage region 131 to the memory 20. In addition, the controller CTL reads out the multiplexed special information from the multiplexed data storage region 135b to the memory 20.

Then, the controller CTL performs ECC correction on the special information read out to the memory 20, and performs error correction (three-valued majority correction) using the multiplexed special information (such as special information multiplexed by three-valued majority voting). Then, the controller CTL updates the special information retained in the memory 20 with the corrected special information. Then, the controller CTL writes the corrected special information into the special information storage region 131. In this manner, the refreshing process is performed on the special information storage region 131.

Note that, after the refreshing process, the multiplexed data storage region 135b is opened as a normal data storage region.

According to the present embodiment, ECC correction and error correction using the multiplexed special information is performed. This allows sufficient error correction even if a bit error rate (BER) of the special information after the solder reflow process is high.

Note that a plurality of multiplexed data storage regions may be provided on the same column address. However, for example, if the reflow resistance varies depending on the location of a memory array, the plurality of multiplexed data storage regions may be provided on column addresses that differ from each other, so that the multiplexed data storage regions are not concentrated in locations having a weak reflow resistance.

### (FOURTH EMBODIMENT)

Next, a fourth embodiment will be described. The semiconductor device of the present embodiment has a configuration similar to that shown in, for example, FIG. 1. However, in the present embodiment, an MRAM-OTP cell configured to use an MRAM as an OTP cell is used for the memory cell of the storage device 30.

FIG. 6 is a drawing showing an example of characteristics of the MRAM-OTP cell according to the fourth embodiment of the present invention. An abscissa of FIG. 6 represents a resistance value of the MRAM-OTP cell which is the memory cell, and an ordinate of FIG. 6 represents a cumulative frequency of the MRAM-OTP cell holding each resistance value.

As shown in FIG. 6, the memory cell switches between a high-resistance state and a low-resistance state in the vicinity of a resistance threshold Rth. For example, the memory cell is in the high-resistance state if the resistance value is higher than the resistance threshold Rth, and is in the low-resistance state if the resistance value is lower than the resistance threshold Rth.

L1 in FIG. 6 indicates characteristics of the MRAM-OTP cell when the memory cell is in the high-resistance state. When the memory cell is in the high-resistance state, the OTP cell is not destroyed. L2 in FIG. 6 indicates characteristics of the MRAM-OTP cell when the OTP cell is not destroyed and the memory cell is in the low-resistance state (low-resistance state by non-destruction). L3 in FIG. 6 indicates characteristics of the MRAM-OTP cell when the OTP cell is destroyed and the memory cell is the low-resistance state (low-resistance state by destruction).

Note that, in the memory cell assuming the low-resistance state, a large current flows by destruction of the OTP cell. For this reason, it is desirable to lower a peripheral resistance in the vicinity of this region. Alternatively, the OTP cell may be arranged in a region having a low peripheral resistance.

As shown in FIG. 6, in a case where the MRAM-OTP cell is used, there are provided a first mode in which write is performed such that the OTP cell is in the low-resistance state by non-destruction, and a second mode in which write is performed such that the OTP cell is in the low-resistance state by destruction. When the first mode is used, it is possible to rewrite data between the high-resistance state and the low-resistance state by non-destruction. For example, in the data storage region 35, the first special information storage region 31 and the second special information storage region 33 described above, when data is to be rewritten freely, writing is performed in the first mode.

On the other hand, when the second mode is used, the OTP cell is destroyed to be switched from the high-resistance state or the low-resistance state by non-destruction to the low-resistance state by destruction. For example, as in the above-described first special information storage region 31, when data (such as initial code) to be completely fixed is written, writing may be performed in the second mode.

In a read operation, the resistance threshold Rth is rate-limiting based on the memory cell in the high-resistance state and the memory cell in the low-resistance state by non-destruction. For this reason, it is possible to perform the read operation using only one type of read mode.

According to the present embodiment, switching between (or providing) two write modes allows the MRAM-OTP to be rewritten and used in a flexible manner. This makes it possible to use the memory cell in a flexible manner even in a case where the OTP cell is used.

### (FIFTH EMBODIMENT)

Next, a fifth embodiment will be described. In the present embodiment, a swap bit storage region is provided in the second special information storage region.

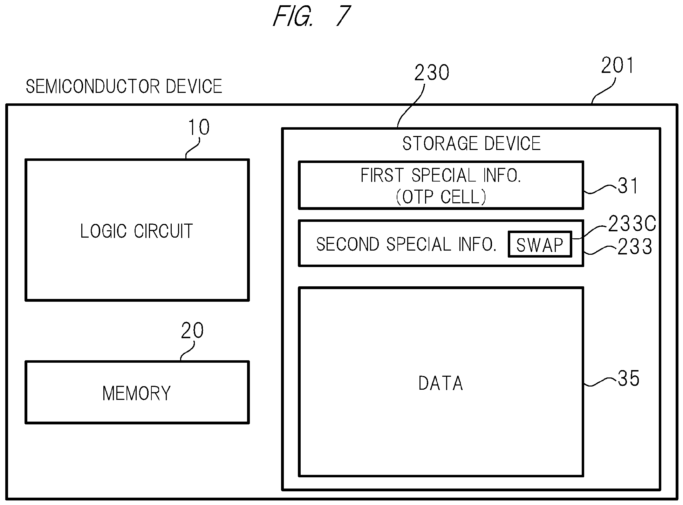

FIG. 7 is a block diagram showing a configuration example of the semiconductor device according to the fifth embodiment of the present invention. As shown in FIG. 7, a recording device 230 of a semiconductor device 201 comprises the first special information storage region 31, a second special information storage region 233, and the data storage region 35.

The first special information storage region 31 is constituted by, for example, the MRAM-OTP cell. The first special information storage region 31 is a storage region into which, for example, special information such as the initial code is written by the above-described second mode. Namely, in the memory cell of the first special information storage region 31, the OTP cell is destroyed after writing is performed. This causes an increase in the reflow resistance of the first special information storage region 31.

On the other hand, the memory cell having a low reflow resistance is used for the second special information storage region 233. For example, the second special information storage region 233 may be constituted by the MRAM-OTP cell, or may be constituted by a different non-volatile memory. The second special information storage region 233 comprises a swap bit storage region 233C in which a swap bit is stored.

The swap bit is a piece of information that is used to select which of the first special information storage region 31 and the second special information storage region 233 is to be used. Normally, the swap bit in the swap bit storage region 233C is set to "0", and the first special information storage region 31 is used. This is in consideration of the reflow resistance (retention properties), and the first special information storage region 31 having the memory cell with a high reflow resistance is selected.

On the other hand, special information for updating received from the outside is written into the second special information storage region 233. However, the special information is written into the first special information storage region 31 by destroying the OTP cell, whereby the data cannot be updated. Namely, the special information for updating written into the second special information storage region 233 cannot be written into the first special information storage region 31 and updated.

In this case, setting the swap bit in the swap bit storage region 233C to "1" allows the second special information storage region 233 to be selected. Then, the special information for updating written into the second special information storage region 233 is used. In this manner, in the present embodiment, the first special information storage region 31 is normally selected. However, in a case where the special information for updating is received from the outside, the second special information storage region 233 is selected.

According to the present embodiment, even in a case where the special information is written by destroying the OTP cell and the special information for updating is received from the outside, it is possible to switch from the first special information storage region 31 to the second special information storage region 233 and use the special information for updating.

In the foregoing, the invention made by the present inventors has been concretely described based on the embodiments. However, it is needless to say that the present invention is not limited to the foregoing embodiments, and various modifications and alterations can be made within the scope of the present invention.

## Claims

1. A semiconductor device comprising:
a logic circuit;
a volatile memory; and
a storage device,
wherein the storage device has:
a first special information storage region into which special information is written before a solder reflow process;
a second special information storage region into which special information for updating is written after the solder reflow process; and
a data storage region,
wherein the first special information storage region is constituted by a memory cell having a high reflow resistance and in which data is retained even after the solder reflow process, and
the second special information storage region and the data storage region are constituted by memory cells having a low reflow resistance and in which data is potentially not retained during the solder reflow process.

2. The semiconductor device according to claim 1,
wherein a capacity of the first special information storage region is larger than that of the second special information storage region, and
the first special information storage region is configured to store special information for an end customer and special information for a third party.

3. A semiconductor device comprising:
a logic circuit;
a volatile memory; and
a storage device,
wherein the storage device has:
a special information storage region into which special information is written before a solder reflow process; and
a data storage region,
wherein the special information storage region and the data storage region are constituted by memory cells having a low reflow resistance in which data is potentially not retained during the solder reflow process, and
after the solder reflow process, a refreshing process is performed on the special information stored in the special information storage region.

4. The semiconductor device according to claim 3,
wherein, during the refreshing process, the logic circuit is configured to read out the special information from the special information storage region to the memory, perform error correction code (ECC) correction on the read-out special information, and write the corrected special information into the special information storage region.

5. The semiconductor device according to claim 3 or 4,
wherein, before the solder reflow process, a multiplexed data storage region into which multiplexed special information is written is set in the data storage region, and
during the refreshing process, the logic circuit is configured to:
read out the special information from the special information storage region to the memory;
read out the multiplexed special information from the multiplexed data storage region to the memory;
perform ECC correction on the read-out special information, and perform error correction using the multiplexed special information; and
write the corrected special information into the special information storage region.

6. The semiconductor device according to claim 5,
wherein the multiplexed special information is information multiplexed by a three-valued majority voting.

7. The semiconductor device according to claim 5 or 6,
wherein, after the refreshing process, the multiplexed data storage region is opened as the data storage region.

8. A semiconductor device comprising:
a logic circuit;
a memory; and
a storage device,
wherein the storage device has:
a first special information storage region into which special information is written before a solder reflow process;
a second special information storage region into which special information for updating is written after the solder reflow process; and
a data storage region,
wherein at least the first special information storage region is constituted by a magnetoresistive random-access memory (MRAM) - one-time programmable (OTP) cell configured to use an MRAM as an OTP cell, and
information is written into the first special information storage region by destroying the OTP cell.

9. The semiconductor device according to claim 8,
wherein the second special information storage region and the data storage region are constituted by the MRAM-OTP cells, and
information is written into the second special information storage region and the data storage region without destroying the OTP cell.

10. The semiconductor device according to claim 8 or 9,
wherein the second special information storage region is provided with a swap bit storage region in which a swap bit is stored, the swap bit being used to select which of the first special information storage region and the second special information storage region is to be used, and
in a case where special information for updating received from the outside is written into the second special information storage region, the swap bit used to select the second special information storage region is stored in the swap bit storage region.
